# EUROPEAN PATENT SPECIFICATION

(11) **EP 3 387 050 B1**
(45) Date of publication and mention of the grant of the patent: **17.02.2021**
(21) Application number: 16806121.6
(22) Date of filing: 06.12.2016
(51) Int. Cl.: C08J 7/04, B32B 17/06, C23C 14/08

(54) **A METHOD OF MANUFACTURING A COATED POLYMER SUBSTRATE HAVING LOW EMISSIVITY**
VERFAHREN ZUR HERSTELLUNG EINES BESCHICHTETEN POLYMERSUBSTRATS MIT GERINGER EMISSIVITÄT
PROCÉDÉ DE FABRICATION D'UN SUBSTRAT POLYMÈRE REVÊTU PRÉSENTANT UNE FAIBLE ÉMISSIVITÉ

(30) Priority: 11.12.2015 EP 15199592
(43) Date of publication of application: 17.10.2018
(73) Proprietor: MICHIELS GROUP, 9250 Waasmunster (BE); Universiteit Gent, 9000 Gent (BE)
(72) Inventor: DE BUYSSER, Klaartje, 9700 Oudenaarde (BE); IDE, Matthias, 9031 Drongen (BE); VAN ZELE, Matthias, 9170 De Klinge (BE); VAN DRIESSCHE, Isabel, 9250 Waasmunster (BE)
(74) Representative: Nederlandsch Octrooibureau
(86) International application number: PCT/EP2016/079943
(87) International publication number: WO 2017/097779

(56) References cited:
- EP-A2- 1 333 065
- WO-A1-2007/046939
- WO-A1-2013/032542
- US-A1- 2004 091 725
- US-A1- 2014 147 649
- US-A1- 2014 154 504

## Description

### Technical Field

The invention relates to a method of manufacturing a coated polymer substrate having low emissivity properties, a high hardness and a good scratch resistance. The invention further relates to a coated polymer substrate and to the use of such coated polymer substrate as low emissivity substrate.

### Background Art

During the last decades thermal insulation of glass surfaces, for example of buildings and vehicles has become more and more important. This is not only driven by the request of more living comfort such as temperature control but is also driven by a growing concern to limit energy consumption.

Low-e (low emissivity) coatings have been developed to minimize the amount of infrared (IR) light that can pass through glass without compromising the amount of visible light that is transmitted.

A first type of low-e coatings known in the art comprises coatings having at least one metal layer. Commonly such low-e coatings comprise at least one sputter deposited silver layer deposited between dielectric layers such as titanium oxide (TiO₂).

However, this type of low-e coatings has some drawbacks. Silver layers have a low stability, a limited hardness, a low durability and poor moisture and weather resistance. Therefore such coatings remain fairly delicate and have to be protected for example by a hard polymer top layer. However, as the presence of such hard polymer top layer results in a high absorption of IR heat, a hard polymer top layer has a negative impact on emissivity of the structure.

A second type of low-e coatings comprise ceramic coatings deposited on a glass substrate. Such coatings are bonded to a glass substrate in a semi-molten state (pyrolytic coating). Typical ceramic coatings comprise oxides such as indium oxide, tin oxide, indium tin oxide or zinc oxide. The oxide becomes part of the glass and as a result, the low-e coatings become more durable. It is clear that such coatings cannot be deposited on polymer substrates as ceramic synthesis needs high temperatures while polymer substrates can hardly resist temperatures above 150 °C.

### Disclosure of Invention

It is an object of the present invention to provide a method to manufacture a coated polymer substrate and to provide a coated polymer substrate having low emissivity properties avoiding the drawbacks of the prior art. It is another object of the present invention to provide a coated polymer substrate combining the features of having a high hardness, a good scratch resistance and low emissivity.

It is a further object of the present invention to provide a coated polymer substrate whereby the coating has excellent adhesion to the polymer substrate. It is still a further object of the present invention to provide a coated polymer substrate whereby a silica or silica-based layer is deposited on a polymer substrate at sufficient low temperatures so that the polymer substrate is not damaged.

It is still a further object to provide the use of a coated polymer substrate as a low emissivity film.

According to a first aspect of the present invention a method to manufacture a coated polymer substrate having low emissivity properties and a high hardness is provided. The method comprises the steps of
- providing a polymer substrate;
- applying an adhesion promoting layer on one side of said polymer substrate;
- applying a silica or silica-based layer on said adhesion promoting layer by a sol-gel process starting from a mixture comprising at least one partially condensed alkoxide precursor.

As polymer substrate any polymer substrate, such as a polymer sheet or foil can be considered. Preferably, the polymer substrate is flexible and transparent. Any material conventionally used for polymer substrate and in particular any material conventionally used for window films or solar control films can be considered. Preferred substrates comprise polymer films comprising polyethylene terephthalate (PET), polyethylene naphthalate (PEN), polyurethane (PU), polycarbonate (PC), polyimide (PI) and polyether imide (PEI). A typical substrate comprises a PET substrate having at thickness ranging between 12 and 125 µm, for example 75 µm.

The silica or silica-based layer is deposited by a sol-gel process. Sol-gel is a known technique to produce for example oxides of silicon. The process involves conversion of monomers into a colloidal solution (sol) and the subsequent reaction to form a network (or gel). In a sol-gel process at least one precursor is dissolved in a suitable liquid, usually water or an organic solvent (for example an alcohol). To catalyse the reaction preferably a catalyst, as for example an acid or a base is added. In the sol-gel process according to the present invention, the sol-gel process starts from a mixture comprising at least one partially condensed alkoxide precursor.

The sol can be deposited on the polymer substrate and more particularly on the adhesion promoting layer deposited on the polymer substrate, for example by wet chemical deposition. The deposited layer can be further cross-linked for example thermally cross-linked or by using radiation (IR and/or UV radiation). By these process steps the solvent and/or water is evaporated.

To obtain an inorganic glass material, the gel is annealed to a temperature above 450 °C in oxygen atmosphere. By this calcination step the organic compounds of the material are calcinated and purely inorganic glass material is obtained. It is clear that a sol-gel layer deposited on a polymer substrate may not be subjected to such high temperatures as the polymer substrate itself may not withstand such temperatures.

Therefore, the sol-gel process according to the present invention is amended to obtain a homogeneous or substantially homogeneous layer that is free or substantially free of organic material and this by using a process that only involves process steps at relatively low temperatures, i.e. temperatures that are sufficiently low to not damage the polymer substrate. With "free of organic material" is meant that the silica or silica-based layer does not comprise organic material.

With "substantially free of organic material" is meant that the amount of organic material present in the silica or silica-based layer is lower than a few weight percent.

Contrary to the silica or silica-based low-e coatings known in the art which have a (multi)crystalline structure, the silica or silica-based coatings of a coated polymer substrate according to the present invention preferably have an amorphous of quasi-amorphous structure.

As mentioned above the sol-gel process according to the present invention preferably starts from a mixture of at least one precursor, a solvent and preferably also a catalyst.

The at least one precursor comprises preferably an alkoxide precursor. The alkoxide precursor is preferably at least partially condensed.

Preferred alkoxide precursors comprise alkoxy silane precursors, for example silanes selected from the group consisting of tetraethoxysilane (TEOS), tetramethoxysilane (TMOS), methyltriethoxysilane (MTES), vinyltrimethoxysilane (VTMS), 3-aminopropyltrimethoxysilane (APS), methacryloxypropyltrimethoxysilane (MAPTS), bis (triethoxysilyl)hexane, 1,6 bis (trimethoxysilyl) hexane or any combination thereof.

The precondensation degree of said silane precursor in the sol is preferably high, i.e. higher than 60 %, higher than 70 %, higher than 80 or higher than 90 %. In a preferred embodiment the mono-, di-, tri- and tetra substituted siloxane bonds designated respectively as Q1, Q2, Q3 and Q4 are fully condensed. The precondensation degree can be determined by NMR.

The solvent preferably comprises an organic solvent for example an alcohol such as methanol or ethanol.

The catalyst preferably comprises at least one base or at least one acid. Preferred catalysts comprise hydrochloric acid, acetic acid or formic acid or any mixture thereof.

The sol-gel coating is applied by any technique known in the art, for example by dipping, spinning, spraying, printing or roll coating.

A preferred technique comprises roll coating. In a roll coating process a liquid film is formed on a continuously moving substrate by using one or more rotating rolls. A preferred roll coating process comprises a gravure coating process. In a gravure coating process a patterned roll, it is a roll provided with cells or grooves is used to apply the coating.

After application of the coating layer, the coated substrate is preferably dried for example in an oven at a temperature of 100 °C.

Possibly, in addition to the drying or instead of the drying the coated substrate is subjected to radiation for example infrared or UV radiation.

The drying and/or the radiation further stimulate(s) the polymerisation of the network and allow(s) the solvent to evaporate.

In order to guarantee a sufficient adhesion of the silica or silica-based layer to the polymer substrate an adhesion promoting layer is applied on the polymer substrate before the application of the silica or silica-based layer.

The adhesion promoting layer comprises a metal oxide, said metal oxide being selected from the group consisting of titanium oxide, indium oxide, tin oxide, zinc oxide, indium tin oxide, niobium oxide, zirconium oxide, either doped or non-doped and any mixture thereof.

The adhesion promoting layer can be deposited by any technique known in the art. Preferred techniques comprise chemical vapour deposition, sputter deposition and evaporation.

According to the second aspect of the present invention a coated polymer substrate having low emissivity properties and a high hardness is provided. The coated polymer substrate comprises
- a polymer substrate;
- an adhesion promoting layer deposited on one side of said polymer substrate;
- a silica or silica-based layer deposited on said adhesion promoting layer. The silica or silica-based layer deposited on the adhesion promoting layer is deposited by a sol-gel process.

The coated polymer substrate according to the present invention is characterised by a low emissivity and a high hardness.

The emissivity of the coated polymer substrate is lower than 0.1, for example lower than 0.06 or lower than 0.04.

The hardness of the coated polymer substrate is at least 2H pencil hardness. More preferably, the hardness of the coated polymer substrate is higher than 3H pencil hardness.

As mentioned above the silica or silica based layer is free or substantially free of organic material.

The silica or silica-based layer has preferably a thickness ranging between 0.1 µm and 1 µm. More preferably, the thickness of the silica or silica-based layer ranges between 0.2 µm and 0.6 µm, such as 0.25 µm or 0.40 µm.

The adhesion promoting layer has a thickness ranging between 0.01 µm and 0.1 µm. More preferably, the thickness of the adhesion promoting layer ranges between 0.02 µm and 0.06 µm, such as 0.04 µm or 0.05 µm.

The adhesion promoting layer comprises a metal oxide, said metal oxide being selected from the group consisting of titanium oxide, indium oxide, tin oxide, zinc oxide, indium tin oxide, niobium oxide, zirconium oxide, either doped or non-doped and any mixture thereof.

According to a third aspect of the invention a glass substrate provided with a coated polymer substrate as described above is provided. The coated polymer substrate is for example adhered to the glass substrate by means of an adhesive.

According to a fourth aspect of the invention the use of a coated polymer substrate as described above as a low emissivity substrate is provided.

### Brief Description of Figures in the Drawings

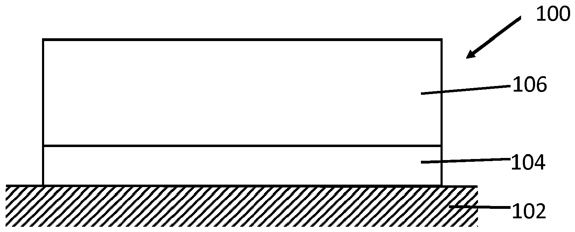

The invention will be further explained by means of the accompanying Figure. The Figure illustrates the cross-section of a coated polymer substrate according to the present invention.

### Mode(s) for Carrying Out the Invention

The present invention will be described with respect to particular embodiments and with reference to certain drawings but the invention is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.

The accompanying figure shows the cross-section of a coated polymer substrate 100 according to the present invention. The coated polymer substrate 100 comprises a polymer substrate 102, an adhesion promoting layer 104 and a silica or silica-based layer 106.

The polymer substrate 102 may comprise any polymer substrate. A preferred polymer substrate 102 comprises a polyester foil having a thickness of 75 µm.

The adhesion promoting layer 104 comprises for example an oxide layer, for example a titanium oxide (Ti02) layer having a thickness ranging preferably between 0.02 µm and 0.04 µm. The Ti02 layer can be deposited by any technique known in the art. A preferred technique to deposit the Ti02 layer is by sputter deposition.

In a preferred preparation of the sol, ethanol was used as solvent and tetraethoxysilane (TEOS) was used as precursor. Possibly an organic linker such as bis (triethoxysilyl)hexane or 1,6 bis (trimethoxysilyl) hexane is added. Hydrochloric acid, acetic acid and formic acid were added as catalysts. The precursor was mixed under brisk stirring and added to the ethanol. Water was first acidified by mixing in the catalyst before it was added to the precursor mixture while stirring. The mixture is stirred until a clear sol was obtained. Precondensation was conducted by keeping the mixture during a certain time period at a predetermined temperature. The mixture was for example kept at 60°C for one hour while stirring and refluxing.

The precondensation degree of said silane precursor in the sol is preferably high, i.e. higher than 60 %, higher than 70 %, higher than 80 or higher than 90 %. In a preferred embodiment the mono-, di-, tri- and tetra substituted siloxane bonds designated respectively as Q1, Q2, Q3 and Q4 are fully condensed. The precondensation degree can be determined by NMR.

The silica or silica-based layer 106 is preferably applied on top of the adhesion promoting layer by roll coating and more preferably by gravure coating. The thickness of the applied layer is for example influenced by the speed of the substrate and the speed of the roll.

The silica or silica coating has a thickness preferably ranging between 0.25 µm and 0.4 µm.

A coated polymer substrate according to the present invention is subjected to a number of tests : hardness test, adhesion tests and low-e measurements. The tests are below described in more detail.

The hardness of the samples was evaluated by means of the Wolff-Wilborn method (ASTM D3363). To perform the tests an Elcometer 501 Pencil Hardness Tester is used. A coated substrate is placed on a firm horizontal surface and a pencil is held firmly against the coating, point away from the operator, at a 45° angle. The pencil is then pushed away from the operator. The hardness of the pencils is increased until one or both of the following defects mark the coating:
a. Plastic deformation : a permanent indentation in the coating surface without cohesive fracture.
b. Cohesive fracture : the presence of a visible scratch or rupture in the surface of the coating, material having been removed from the coating.
The degree of hardness of the pencil which damages the surface is taken as a measurement of scratch hardness e.g. '2H' hardness.

The adhesion of the coating to the substrate is determined by a cross-hatch test. A cross-hatch test is a method to determine the resistance of coatings to separation from a substrate by utilizing a tool to cut a right angle lattice pattern into the coating penetrating all the way to the substrate.

In the cross-hatch test a cross-hatch pattern is made through the coating to the substrate. In a next step detached flakes of coating are removed by brushing with a soft brush. Subsequently pressure-sensitive tape is applied over the crosshatch cut. The tape is smoothed into place by using a pencil eraser over the area of the incisions. The tape is then removed by pulling it off rapidly back over itself as close to an angle of 180°. The adhesion is assessed on a 0 to 5 scale. The 0 to 5 scale is further explained in Table 1.

**Table 1**

| | |
|---|---|
| 0 | the edges of the cuts are completely smooth, none of the squares of the lattice is detached. |
| 1 | detachment of small flakes of the coating at the intersections of the cuts. A cross-cut area not greater than 5 % is affected. |
| 2 | the coating has flaked along the edges and at the intersections of the cuts. A cross-cut area greater than 5 % but not greater than 15 % is affected. |
| 3 | The coating has flaked along the edges of the cuts partly of wholly in large ribbons, and it has flaked partly or wholly on different parts of the squares. A cross-cut area greater than 15 %, but not greater than 35 % is affected. |
| 4 | The coating has flaked along the edges of the cuts in large ribbons and some squares have detached partly or wholly. A cross-cut area greater than 35 % but not greater than 65 % is affected. |
| 5 | Any greater degree of flaking that cannot even be classified by classification 4. |

The emissivity of the samples is measured by subjecting the surface to be measured to the thermal radiation of the black body at a temperature of 100°C for a short time. To obtain complete homogenous illumination of the measuring surface the radiator is designed in the form of a spherical half-space. A portion of the reflected radiation hits the radiation sensor through an opening in the radiator.

Determination of the emission level results from the comparison between the reflection values of the sample and the stored reference values of two calibrated standards. In the test TIR 100-2 apparatus was used, the calibrated standards were 0.010 and 0.962.

For the sample described above and illustrated in the accompanying figure the following results were obtained :
Hardness : 3 H pencil hardness
Adhesion test (cross-hatch test) : class 0
Emissivity test: E= 0.04

## Claims

1. A method to manufacture a coated polymer substrate having an emissivity lower than 0.1 and a hardness of at least 2H pencil hardness, said method comprising the steps of
- providing a polymer substrate;
- applying an adhesion promoting layer on one side of said polymer substrate;
- applying a silica or silica-based layer on said adhesion promoting layer by a sol-gel process, starting from a mixture comprising at least one partially condensed alkoxide precursor, wherein the adhesion promoting layer has a thickness ranging between 0.01 µm and 0.1 µm, and wherein the adhesion promoting layer comprises a metal oxide, said metal oxide being selected from the group consisting of titanium oxide, indium oxide, tin oxide, zinc oxide, indium tin oxide, niobium oxide, zirconium oxide, either doped or non-doped and any mixture thereof.

2. A method according to claim 1, wherein said silica or silica-based layer is obtained starting from a mixture comprising at least one partially condensed alkoxide precursor, a solvent and a catalyst.

3. A method according to claim 1 or claim 2, wherein said at least one partially condensed alkoxide precursor has a condensation degree of at least 60 %.

4. A method according to claim 3, wherein said alkoxide precursor is fully condensed in the sol.

5. A method according to any one of the preceding claims, wherein said alkoxide precursor is an alkoxy silane, preferably a silane selected from the group consisting of tetraethoxysilane (TEOS), tetramethoxysilane (TMOS), methyltriethoxysilane (MTES), vinyltrimethoxysilane (VTMS), 3-aminopropyltrimethoxysilane (APS), methacryloxypropyltrimethoxysilane (MAPTS), bis (triethoxysilyl)hexane, 1,6 bis (trimethoxysilyl) hexane or any combination thereof.

6. A method according to any one of claim 2 to 5, wherein said catalyst comprises at least one base or at least one acid.

7. A method according to any one of the preceding claims, wherein said silica or silica-based layer is deposited by roll coating.

8. A method according to any of the preceding claims, wherein said adhesion promoting layer is deposited by sputter deposition.

9. A coated polymer substrate having low emissivity properties, said coated polymer substrate comprising
- a polymer substrate;
- an adhesion promoting layer deposited on one side of said polymer substrate;
- a silica or silica-based layer deposited on said adhesion promoting layer, said silica or silica-based layer being deposited by a sol-gel process, starting from a mixture comprising at least one partially condensed alkoxide precursor, said coated polymer substrate is having an emissivity lower than 0.1 and said silica or silica-based layer having a hardness of at least 2H pencil hardness, wherein the adhesion promoting layer has a thickness ranging between 0.01 µm and 0.1 µm, and wherein the adhesion promoting layer comprises a metal oxide, said metal oxide being selected from the group consisting of titanium oxide, indium oxide, tin oxide, zinc oxide, indium tin oxide, niobium oxide, zirconium oxide, either doped or non-doped and any mixture thereof.

10. A coated polymer substrate according to claim 9, wherein said silica or silica-based layer has a thickness ranging between 0.1 µm and 1 µm.

11. A glass substrate provided with a coated polymer substrate as defined in claim 9 or claim 10.

12. The use of a coated substrate as defined in claim 9 or claim 10 as a substrate having low emissivity properties.

## Patentansprüche

1. Ein Verfahren zum Herstellen eines beschichteten Polymersubstrats, welches eine Emissivität von weniger als 0,1 und eine Härte von mindestens 2H Bleistift Härte hat, das Verfahren aufweisend die Schritte
- Bereitstellen eines Polymersubstrats;
- Auftragen einer Adhäsion-fördernden Schicht auf einer Seite des Polymersubstrats;
- Auftragen einer Silica- oder Silica-basierten Schicht auf der Adhäsion-fördernden Schicht mittels eines Sol-Gel Verfahrens, beginnend mit einer Mischung aufweisend mindestens eine teilweise kondensierte Alkoxid-Vorstufe, wobei die Adhäsion-fördernde Schicht eine Dicke hat zwischen 0,01 µm und 0,1 µm und wobei die Adhäsion-fördernde Schicht aufweist ein Metalloxid, wobei das Metalloxid gewählt ist aus der Gruppe bestehend aus Titanoxid, Indiumoxid, Zinnoxid, Zinkoxid, Indium-Zinn-Oxid, Niob-Oxid, Zirkonoxid, entweder dotiert oder nicht-dotiert und jegliche Mischung daraus.

2. Ein Verfahren gemäß Anspruch 1, wobei die Silica- oder Silica-basierte Schicht erhalten wird beginnend mit einer Mischung aufweisend mindestens eine teilweise kondensierte Alkoxid-Vorstufe, ein Lösungsmittel und ein Katalysator.

3. Ein Verfahren gemäß Anspruch 1 oder 2, wobei die mindestens eine teilweise kondensierte Alkoxid-Vorstufe einen Kondensationsgrad von mindestens 60 % hat.

4. Ein Verfahren gemäß Anspruch 3, wobei die Alkoxid-Vorstufe voll kondensiert ist in dem Sol.

5. Ein Verfahren gemäß irgendeinem der vorangegangenen Ansprüche, wobei die Alkoxid-Vorstufe ein Alkoxy-Silan ist, vorzugsweise ein Silan gewählt aus der Gruppe bestehend aus Tetraethoxysilan (TEOS), Tetramethoxysilan (TMOS), Methyltriethoxysilan (MTES), Vinyltrimethoxysilan (VTMS), 3-Aminopropyltrimethoxysilan (APS), Methacryloxypropyltrimethoxysilan (MAPTS), Bis-(triethoxysilyl)-hexan, 1,6-bis-(trimethoxysilyl)-Hexan oder jegliche Kombination davon.

6. Ein Verfahren gemäß irgendeinem der Ansprüche 2 bis 5, wobei der Katalysator aufweist mindestens eine Base oder mindestens eine Säure.

7. Ein Verfahren gemäß irgendeinem der vorangegangenen Ansprüche, wobei die Silica- oder Silica-basierte Schicht aufgebracht wird mittels Walzenstreichen.

8. Ein Verfahren gemäß irgendeinem der vorangegangenen Ansprüche, wobei die Adhäsion-fördernde Schicht aufgebracht wird mittels Spritzaufbringung.

9. Ein beschichtetes Polymersubstrat mit niedrigen Emissivität Eigenschaften, das beschichtetes Polymersubstrat aufweisend
- ein Polymersubstrat;
- eine Adhäsion-fördernde Schicht, aufgebracht auf einer Seite des Polymersubstrats;
- eine Silica- oder Silica-basierte Schicht, aufgebracht auf der Adhäsion-fördernden Schicht, wobei die Silica- oder Silica-basierte Schicht aufgebracht wird mittels eines Sol-Gel Verfahrens, beginnend mit einer Mischung aufweisend mindestens eine teilweise kondensierte Alkoxid-Vorstufe, wobei das beschichtetes Polymersubstrat eine Emissivität von weniger als 0,1 hat und die Silica- oder Silica-basierte Schicht eine Härte von mindestens 2H Bleistift Härte hat, wobei die Adhäsion-fördernde Schicht eine Dicke hat zwischen 0,01 µm und 0,1 µm und wobei die Adhäsion-fördernde Schicht aufweist ein Metalloxid, wobei das Metalloxid gewählt ist aus der Gruppe bestehend aus Titanoxid, Indiumoxid, Zinnoxid, Zinkoxid, Indium-Zinn-Oxid, Niob-Oxid, Zirkonoxid, entweder dotiert oder nicht-dotiert und jegliche Mischung daraus.

10. Ein beschichtetes Polymersubstrat gemäß Anspruch 9, wobei die Silica- oder Silica-basierte Schicht eine Dicke hat zwischen 0,1 µm und 1 µm.

11. Ein Glas Substrat bereitgestellt mit einem beschichteten Polymersubstrat wie definiert in Anspruch 9 oder 10.

12. Die Verwendung eines beschichteten Substrats wie definiert in Anspruch 9 oder Anspruch 10 als ein Substrat mit niedrigen Emissivität Eigenschaften.

## Revendications

1. Procédé de fabrication d'un substrat polymère revêtu ayant une émissivité inférieure à 0,1 et une dureté d'au moins 2H de dureté au crayon, ledit procédé comprenant les étapes consistant à :
- partir d'un substrat polymère ;
- appliquer une couche favorisant l'adhérence sur un côté dudit substrat polymère ;
- appliquer une couche de silice ou à base de silice sur ladite couche favorisant l'adhérence par un procédé sol-gel, à partir d'un mélange comprenant au moins un précurseur d'alcoxyde partiellement condensé, dans lequel la couche favorisant l'adhérence a une épaisseur comprise entre 0,01 µm et 0,1 µm, et dans lequel la couche favorisant l'adhérence comprend un oxyde métallique, ledit oxyde métallique étant choisi dans le groupe constitué par l'oxyde de titane, l'oxyde d'indium, l'oxyde d'étain, l'oxyde de zinc, l'oxyde d'indium-étain, l'oxyde de niobium, l'oxyde de zirconium, qu'il soit dopé ou non dopé, et un mélange quelconque de ceux-ci.

2. Procédé selon la revendication 1, dans lequel ladite couche de silice ou à base de silice est obtenue à partir d'un mélange comprenant au moins un précurseur d'alcoxyde partiellement condensé, un solvant et un catalyseur.

3. Procédé selon la revendication 1 ou la revendication 2, dans lequel ledit au moins un précurseur d'alcoxyde partiellement condensé a un degré de condensation d'au moins 60%.

4. Procédé selon la revendication 3, dans lequel ledit précurseur d'alcoxyde est complètement condensé dans le sol.

5. Procédé selon l'une quelconque des revendications précédentes, dans lequel ledit précurseur d'alcoxyde est un alcoxysilane, de préférence, un silane choisi dans le groupe constitué par le tétraéthoxysilane (TEOS), le tétraméthoxysilane (TMOS), le méthyltriéthoxysilane (MTES), le vinyltriméthoxysilane (VTMS), le 3-aminopropyltriméthoxysilane (APS), le méthacryloxypropyltriméthoxysilane (MAPTS), le bis(triéthoxysilyl)hexane, le 1,6-bis(triméthoxysilyl)hexane ou une combinaison quelconque de ceux-ci.

6. Procédé selon l'une quelconque des revendications 2 à 5, dans lequel ledit catalyseur comprend au moins une base ou au moins un acide.

7. Procédé selon l'une quelconque des revendications précédentes, dans lequel ladite couche de silice ou à base de silice est déposée par revêtement au rouleau.

8. Procédé selon l'une quelconque des revendications précédentes, dans lequel ladite couche favorisant l'adhérence est déposée à l'aide d'un dépôt par pulvérisation cathodique.

9. Substrat polymère revêtu ayant des propriétés de faible émissivité, ledit substrat polymère revêtu comprenant :
- un substrat polymère ;
- une couche favorisant l'adhérence, déposée sur un côté dudit substrat polymère ;
- une couche de silice ou à base de silice déposée sur ladite couche favorisant l'adhérence, ladite couche de silice ou à base de silice étant déposée par un procédé sol-gel, à partir d'un mélange comprenant au moins un précurseur d'alcoxyde partiellement condensé, ledit substrat polymère revêtu ayant une émissivité inférieure à 0,1 et ladite couche de silice ou à base de silice ayant une dureté d'au moins 2H de dureté au crayon, dans lequel la couche favorisant l'adhérence a une épaisseur comprise entre 0,01 µm et 0,1 µm, et dans lequel la couche favorisant l'adhérence comprend un oxyde métallique, ledit oxyde métallique étant choisi dans le groupe constitué par l'oxyde de titane, l'oxyde d'indium, l'oxyde d'étain, l'oxyde de zinc, l'oxyde d'indium-étain, l'oxyde de niobium, l'oxyde de zirconium, qu'il soit dopé ou non dopé, et un mélange quelconque de ceux-ci.

10. Substrat polymère revêtu selon la revendication 9, dans lequel ladite couche de silice ou à base de silice a une épaisseur comprise entre 0,1 µm et 1 µm.

11. Substrat de verre muni d'un substrat polymère revêtu tel que défini dans la revendication 9 ou la revendication 10.

12. Utilisation d'un substrat revêtu tel que défini dans la revendication 9 ou la revendication 10 comme substrat ayant des propriétés de faible émissivité.
